(19) Europäisches Patentamt
European Patent Office
Office européen des brevets

(11) **EP 4 123 320 B1**

(12) **EUROPÄISCHE PATENTSCHRIFT**

(45) Veröffentlichungstag und Bekanntmachung des Hinweises auf die Patenterteilung:
**13.03.2024 Patentblatt 2024/11**

(21) Anmeldenummer: **21187494.6**

(22) Anmeldetag: **23.07.2021**

(51) Internationale Patentklassifikation (IPC):
**G01R 31/367** *(2019.01)*    **G01R 31/382** *(2019.01)*
**G01R 31/385** *(2019.01)*    **G01R 31/392** *(2019.01)*

(52) Gemeinsame Patentklassifikation (CPC):
**G01R 31/367; G01R 31/382; G01R 31/386;**
**G01R 31/392;** Y02E 60/10

(54) **VERFAHREN ZUM BESTIMMEN EINES KAPAZITÄTSVERLUSTS EINES BATTERIESPEICHERS, VORRICHTUNG UND COMPUTERPROGRAMMPRODUKT**

METHOD FOR DETERMINING A CAPACITY LOSS OF A BATTERY, DEVICE AND COMPUTER PROGRAM PRODUCT

PROCÉDÉ DE DÉTERMINATION D'UNE PERTE DE CAPACITÉ D'UNE BATTERIE, DISPOSITIF ET PRODUIT-PROGRAMME INFORMATIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.01.2023 Patentblatt 2023/04**

(73) Patentinhaber: **Siemens Aktiengesellschaft**
**80333 München (DE)**

(72) Erfinder: **Arzberger, Arno**
**96135 Stegaurach (DE)**

(74) Vertreter: **Siemens Patent Attorneys**
**Postfach 22 16 34**
**80506 München (DE)**

(56) Entgegenhaltungen:
**WO-A1-2021/089786**

- ZHANG SHUZHI ET AL: "A rapid online calculation method for state of health of lithium-ion battery based on coulomb counting method and differential voltage analysis", JOURNAL OF POWER SOURCES, ELSEVIER, AMSTERDAM, NL, Bd. 479, 31. August 2020 (2020-08-31), XP086345101, ISSN: 0378-7753, DOI: 10.1016/J.JPOWSOUR.2020.228740 [gefunden am 2020-08-31]
- ZHENG YUEJIU ET AL: "Study on the correlation between state of charge and coulombic efficiency for commercial lithium ion batteries", JOURNAL OF POWER SOURCES, ELSEVIER, AMSTERDAM, NL, Bd. 289, 18. Mai 2015 (2015-05-18), Seiten 81-90, XP029242205, ISSN: 0378-7753, DOI: 10.1016/J.JPOWSOUR.2015.04.167

**Beschreibung**

Die Erfindung betrifft ein Verfahren zum Bestimmen eines Kapazitätsverlusts eines Batteriespeichers, insbesondere der Bestimmung einer voraussichtlichen Alterung des Batteriespeichers, eine Vorrichtung zum Durchführen des Verfahrens und ein Computerprogrammprodukt.

Lithium-Ionen-Akkumulatoren, im Folgenden auch Lithium-Ionen-Batterien genannt, werden aufgrund ihrer hohen Leistungs- und Energiedichte in mobilen und stationären Anwendungen als Energiespeicher eingesetzt. Um diese elektrochemischen Energiespeicher sicher, zuverlässig und möglichst lange wartungsfrei betreiben zu können, ist eine möglichst genaue Kenntnis kritischer Betriebszustände, insbesondere hinsichtlich des Ladezustands (engl.: State of Charge, SOC) und hinsichtlich des Alterungszustands (engl: State of Health, SOH), nötig.

Es ist bekannt, dass die Alterung einer Batterie, insbesondere die sogenannte zyklische Alterung durch hohe Temperaturen, das schnelle Laden bei niedrigen Temperaturen, in Abhängigkeit des Ladezustands und der Entladetiefe und der Ladeleistung und Entladeleistung negativ beeinflusst werden kann. Es ist somit möglich, dass derselbe Typ einer Batteriezelle in Abhängigkeit von den genannten Parametern eine deutlich unterschiedliche Anzahl von Lastzyklen bewerkstelligen kann.

Zur Bestimmung des erwartbaren Alterungsverlaufs wird im Stand der Technik mittels Messungen während der Auslegungsphase eines Batteriesystems eine Alterungscharakteristik der verwendeten Batteriezelle bestimmt. Die reale Alterungsgeschwindigkeit mit realen Lastprofilen wird häufig nicht getestet. Vielmehr wird in sogenannten Rafftests die Alterungsgeschwindigkeit, oder die Zyklenstabilität, an komprimierten Lastprofilen bestimmt. Mit diesen Ergebnissen werden empirische Alterungsmodelle parametriert, aus welchen der Alterungsverlauf in der Anwendung hervorgeht. Eine basierend auf physikalischen und/oder chemischen Messungen ermittelter Verlauf der zukünftigen Alterung in Abhängigkeit des Lastprofils, des Arbeitspunkts und der Umgebungsbedingungen ist aufgrund der Nichtlinearität der zugrundeliegenden physikalischen und chemischen Prozesse und deren komplexen Wechselwirkungen nur schwer durchzuführen. Aus dem Artikel : Zhang Shuzhui et AI : "A rapid online calculation method for state of health of lithium-ion battery based on Coulomb counting method and differential voltage analysis", J. of Power Source, Vol 479, 2020 ist ein ähnliches Verfahren bekannt.

Eine verbesserte Messung des Kapazitätsverlusts und Abschätzung der Alterung im tatsächlichen Betrieb ist mit einem Verfahren der High-Precision Coulometry (HPC) möglich. Bei der HPC-Messung werden Lastzyklen durchfahren und aus dem Verlauf von Kapazitätsmessungen der Kapazitätsverlust ermittelt.

Bei der HPC-Messung werden verhältnismäßig kleine Unterschiede in den Ladungsmengen, die in die Batterie geladen und aus ihr entnommen werden, über die Integration von gemessenen Stromstärken bestimmt. Daher erfordert die HPC-Messung grundsätzlich eine sehr hohe Messgenauigkeit, insbesondere in der Strommessung. Diese hohe Messgenauigkeit kann, wenn überhaupt, nur von speziell für die HPC-Messung vorgesehenen Testgeräten eingehalten werden.

Typische Testgeräte der Art, die in der Batterieproduktion eingesetzt werden, sind wegen zu hoher Messunsicherheit überhaupt nicht aussagekräftig.

Es ist Aufgabe der vorliegenden Erfindung, ein Verfahren und eine Vorrichtung anzugeben, die eine Verbesserung der intrinsischen Genauigkeit von HPC-Messungen ermöglichen.

Die Aufgabe wird mit einem Verfahren zum Ermitteln eines Kapazitätsverlusts gemäß Anspruch 1, einer Vorrichtung gemäß Anspruch 14 und einem Computerprogrammprodukt gemäß Anspruch 15 gelöst.

Bei dem erfindungsgemäßen Verfahren zum Ermitteln wenigstens eines mittleren Kapazitätsverlusts eines Batteriespeichers werden Ergebnissen einer Messreihe an dem Batteriespeicher mit einer Mehrzahl von Lastzyklen bereitgestellt. Dabei umfassen die Lastzyklen eine Ladungsphase und eine Entladungsphase. Die Ergebnisse umfassen Werte einer Strommessung zu den Lastzyklen, also der Ladung und Entladung.

Aus den Ergebnissen der Messreihe werden weiterhin eine erste und eine zweite Entlade-Kapazität des Batteriespeichers durch eine erste und eine zweite Rechenvorschrift ermittelt. Dabei werden solche Rechenvorschriften verwendet, dass eine Kalibrierung der Strommessung unterschiedlich in die erste und zweite Rechenvorschrift eingeht. Die Kalibrierung ist dabei der Zusammenhang zwischen dem tatsächlich vorliegenden Strom und dem Wert der Strommessung.

Schließlich wird ein Optimierungsverfahren derart durchgeführt, dass eine Kalibrierung der Strommessung ermittelt wird, mit der die größte Übereinstimmung der ermittelten ersten und zweiten Ladekapazität erreicht ist.

Die erfindungsgemäße Vorrichtung zum Durchführen des Verfahrens nach einem der vorangehenden Ansprüche umfasst einen Speicher zur Aufnahme von Ergebnissen einer Messreihe an dem Batteriespeicher mit einer Mehrzahl von Lastzyklen. Dabei umfassen die Lastzyklen eine Ladungsphase und eine Entladungsphase und die Ergebnisse umfassen Werte einer Strommessung.

Die Vorrichtung umfasst ferner eine Recheneinheit. Diese ist ausgestaltet, eine Berechnung einer ersten und einer zweiten Entlade-Kapazität des Batteriespeichers aus den Ergebnissen der Messreihe durch eine erste und eine zweite Rechenvorschrift durchzuführen. Dabei geht eine Kalibrierung der Strommessung unterschiedlich in die erste und zweite Rechenvorschrift ein, wobei die Kalibrierung der Zusammenhang zwischen dem tatsächlich vorliegenden Strom und dem Wert der Strommessung ist.

Die Recheneinheit ist weiterhin ausgestaltet, ein Optimierungsverfahren derart durchzuführen, dass eine Kalibrierung der Strommessung ermittelt wird, mit der die größte Übereinstimmung der ermittelten ersten und zweiten Ladekapazität erreicht ist.

Das erfindungsgemäße Computerprogrammprodukt ist direkt in einen Speicher einer programmierbaren Recheneinheit ladbar. Es umfasst Programmcode-Mittel, um das erfindungsgemäße Verfahren auszuführen, wenn das Computerprogrammprodukt in der Recheneinheit ausgeführt wird.

Es versteht sich, dass die Optimierung zweckmäßig computergestützt in einer Recheneinheit erfolgt.

Mit dem erfindungsgemäßen Vorgehen wird erreicht, dass Ungenauigkeiten der Messung der Batterieeigenschaften, speziell in Form der Messung der Ladungsmengen, die durch eine fehlerhafte, also ungenaue Kalibrierung der Strommessung entstehen, entfernt werden. Für die Erfindung wurde erkannt, dass sich aus den Strommessungen, die bei einer Vermessung von Lastzyklen aufgenommen werden, zumindest zwei Ladungswerte bestimmen lassen, die nominell übereinstimmen, bei denen die Kalibrierung der Strommessung aber unterschiedlich stark in das Ergebnis eingeht. Dadurch lässt sich der Einfluss der Kalibrierung eliminieren.

Vorteilhaft wird dadurch die Messgenauigkeit speziell auch bei HPC-Testern erhöht. Auch solche, bei denen die Kalibrierung werksseitig zu ungenau ist, können so verwendet und mit dem erfindungsgemäßen Verfahren - im Zuge der Vermessung einer Batterie - genau kalibriert werden. Weiterhin werden sogar aussagekräftige HPC-Messungen auf "Standard-Testern" ermöglicht, mit denen ohne das erfindungsgemäße Verfahren keine sinnvolle Messung mit der nötigen Genauigkeit möglich wäre.

Die Ergebnisse der Messreihe umfassen dabei Werte von Strommessungen, die geeignet sind für eine Summierung, die einer zeitlichen Integration nahekommt. Es handelt sich mit anderen Worten um eine Vielzahl von Messwerten. Die Messwerte liegen dabei typischerweise als elektrische Signale, beispielsweise als digitale Signale vor. Die Ergebnisse der Messreihe können auch Spannungswerte umfassen, insbesondere Spannungswerte, die den Stromwerten zugeordnet sind.

Unter dem Optimierungsverfahren wird ein Verfahren verstanden, das beispielsweise eine Zielfunktion minimiert, wobei zur Minimierung bestimmte vorgesehene Parameter der Zielfunktion variiert werden dürfen. Optimierungsverfahren funktionieren typischerweise iterativ und sind nicht durch eine analytische Lösung ersetzbar. Im vorliegenden Fall kann beispielsweise die zu minimierende Zielfunktion der Betrag der Differenz der ersten und zweiten Ladekapazität sein. Die zu variierenden Parameter sind die Parameter, die die Kalibrierung der Strommessung ausmachen.

Unter der Bereitstellung der Messergebnisse kann verstanden werden, dass diese schon vorliegen und somit nur aufgenommen und verarbeitet werden. Die eigentliche Messung hat in diesem Fall vorab stattgefunden, kann also räumlich und zeitlich getrennt stattfinden. Es ist aber auch möglich, dass die Messergebnisse im Zuge eine Messung sofort bereitgestellt und verarbeitet werden, also die Messung zusammen mit dem Verfahren stattfindet.

Vorteilhafte Ausgestaltungen des erfindungsgemäßen Verfahrens gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für das Verfahren noch zusätzlich folgende Merkmale vorgesehen werden:
Die erste Entlade-Kapazität für einen Lastzyklus kann aus einer Entladedrift für den Lastzyklus und einer Coulomb-Effizienz für den Lastzyklus berechnet werden. Dazu kann beispielsweise die untenstehende Gleichung 3 als Rechenvorschrift verwendet werden. Unter der Entladedrift wird die Differenz zweier aufeinander folgender Ladezustände im unteren Ladezustand des Ladezyklus, d.h. nach der Entladung verstanden, beispielsweise berechnet mittels Gleichung 5. Die Coulomb-Effizienz oder Coulomb-Wirkungsgrad bezeichnet das Verhältnis der durch die Entladung entnommenen Energie zur durch die vorhergehende Ladung zugeführten Energie; hierfür kann Gleichung 4 verwendet werden.

Die erste Entlade-Kapazität für einen Lastzyklus kann alternativ aus einem Kapazitätswert nach der Ladephase des Lastzyklus und einem Kapazitätswert vor dieser Ladephase berechnet werden.

Die zweite Entlade-Kapazität für einen Lastzyklus kann aus einer ersten Entlade-Kapazität für einen weiteren, vorangehenden Lastzyklus und einer Summe aus Kapazitätsverlusten von zwischen dem Lastzyklus und dem weiteren Lastzyklus liegenden Lastzyklen ermittelt werden. Eine entsprechende Gleichung zur Berechnung ist in Gleichung 6 gegeben. Unter den Kapazitätsverlusten wird die Differenz der Ladedrift und der bereits verwendeten Entladedrift verstanden wie angegeben in Gleichung 7. Als Ladedrift wird in Analogie zur Entladedrift die Differenz zweier aufeinander folgender Ladezustände im oberen Ladezustand des Ladezyklus, d.h. nach der Ladung verstanden, beispielsweise berechnet mittels Gleichung 8.

Für die Berechnung und Optimierung der Kalibrierung kann ein Offset-Wert verwendet werden, der eine Differenz zwischen realem und gemessenem Stromwert bei einem Strom von 0 A angibt. Weiterhin kann ein Steigungswert verwendet werden, der einen Proportionalitätsfaktor zwischen realem und gemessenem Strom angibt. Dies entspricht einer Abbildung des Stromverlaufs mittels eines Polynoms ersten Grades, also einer Geraden. Mit dem realen Strom kann hierbei beispielsweise ein elektrisches Rohsignal aus einer Messung gemeint sein.

Eine solche Kalibrierung ist einfach und universell und bildet die typischen Verhältnisse einer Strommessung ab. Darin entspricht der Offset einem Nullwert eines verwendeten AD-Wandlers, während der Steigungswert oder Gain den elektrischen Widerstand abbildet, der als Shunt für die Strommessung verwendet wird und dessen Größe einer Exemplarstreuung unterliegt und daher nicht genau der Spezifikation entspricht.

Alternativ kann für die Berechnung und Optimierung der Kalibrierung ein Krümmungsfaktor verwendet werden, der einen nichtlinearen, insbesondere quadratischen Zusammenhang zwischen realem und gemessenem Strom angibt. Zusammen mit dem Offset und Gain wird dadurch ein Polynom zweiten Grades verwirklicht, das eine noch genauere Anpassung an die reale Messung erlaubt.

Alternativ kann für die Berechnung und Optimierung der Kalibrierung der Zusammenhang zwischen realem und gemessenem Strom als ein abschnittsweise linearer Zusammenhang mit drei oder mehr Stützpunkten modelliert werden. Diese Vorgehensweise erlaubt eine genauere Modellierung als die einfache Gerade und durch Steigerung der Anzahl der Stützpunkte im Prinzip eine beliebige Genauigkeit, die völlig unabhängig von der tatsächlichen Form des Zusammenhangs zwischen realem Strom und Messwert ist.

Die Ergebnisse der Messreihe werden bevorzugt mittels einer Hoch-Präzisions-Coulometrie-Vorrichtung erzeugt. Diese sind speziell für diese Art von Messung ausgelegt und eine noch vorhandene Ungenauigkeit der Strommessung kann ideal mit dem erfindungsgemäßen Vorgehen ausgeglichen werden.

Es werden bevorzugt solche Lastzyklen verwendet, bei denen das Laden und Entladen stets zwischen einer festlegbaren unteren Spannung und einer festlegbaren oberen Spannung des Batteriespeichers erfolgt.

Dabei wird bevorzugt sichergestellt, dass in jedem aufeinanderfolgenden Lastzyklus innerhalb des Lastzyklus eine konstante Temperatur herrscht. Dadurch werden temperaturbedingte Ungenauigkeiten der Messung verringert.

Bevorzugt werden bei der Messung Lastzyklen durchgeführt, bis ein Kapazitätsverlust in zwei oder mehr aufeinanderfolgenden Lastzyklen nahezu konstant ist. Die ermittelten Kapazitätsverluste werden als nahezu konstant angesehen, wenn eine Steigung einer Tangente, welche an den Verlauf der Kapazitätsverluste angepasst wurden, betragsmäßig einen Wert kleiner als 10 % des Mittelwertes der Steigungen der letzten 10 % der gemessenen Kapazitätsverluste aufweisen. Alternativ werden die Kapazitätsverluste als nahezu oder im Wesentlichen konstant angesehen, wenn eine absolute Änderung wenigstens zweier aufeinanderfolgender Kapazitätsverluste insbesondere weniger als 5 % beträgt.

Für die weitere Verwendung der Messergebnisse kann ein mittlerer Kapazitätsverlust ermittelt werden. Dieser ergibt sich als Mittelwert aus einer Mehrzahl von Kapazitätsverlusten für verschiedene Lastzyklen. Der mittlere Kapazitätsverlust beschreibt die Alterungsgeschwindigkeit für einen gewählten Lastzyklus in der Einheit Kapazitätsverlust pro Zyklus. Vorteilhaft kann dadurch eine quantitative Auswertung der Messdaten der Hoch-Präzisions-Coulometrie-Vorrichtung hinsichtlich der Alterungsgeschwindigkeit der Batterie vorgenommen werden. Die quantitative Auswertung ist möglich, da basierend auf dem Ermitteln des mittleren Kapazitätsverlusts absolute Werte für die Kapazität ermittelt werden können. Der verwendete Lastzyklus definiert dabei durch die Auswahl der Spannungsgrenzen einen bestimmten Arbeitspunkt, charakterisiert durch einen mittleren Ladezustand (SOC) und eine Zyklentiefe (DOD).

Vorteilhaft erfolgt die Bestimmung des mittleren Kapazitätsverlusts computergestützt durch einen gleitenden linearen Fit über die Werte des Kapazitätsverlusts und das Auffinden der kleinsten Steigungen in den so erzeugten Geradengleichungen. Ausgehend von einem Fit über alle Kapazitätsverluste wird der Datensatz, welcher die ermittelten Kapazitätsverluste umfasst, laufend gekürzt und eine neue Gerade gefittet. Der Fit wird bis zu einer bestimmten minimalen Restlänge des Datensatzes, also der Kapazitätsverluste, durchgeführt. Im Anschluss werden die Geradengleichungen nach den Werten ihrer Steigungen der Größe nach ansteigend sortiert. Die Messung kann dann als gültig angesehen werden, wenn wenigstens zwei der Steigungen betragsmäßig einen Wert kleiner als 10 % des Mittelwertes der letzten 10 % der Kapazitätsverluste aufweisen. Beträgt beispielsweise der Mittelwert der letzten zwanzig Kapazitätsverluste, insbesondere bei einer Messung von wenigstens 200 Kapazitätsverlusten, 5 mAh/Lastzyklus, dann sollte sie Steigung der beiden besten angepassten Tangenten ("Fits") weniger als 0,05 mAh/Lastzyklus aufweisen.

Besonders vorteilhaft ist es, wenn Kapazitätsverluste erst nach einer Einschwingphase des Lastzyklus zum Ermitteln der Restkapazität herangezogen werden. Kapazitätsverluste, die zu Beginn der Messungen, also während des Einschwingvorgangs, ermittelt werden, sind fehlerbehaftet und sollten somit nicht in die Ermittlung des mittleren Kapazitätsverlusts einbezogen werden. Es hat sich herausgestellt, dass diese Einschwingphase beendet ist, wenn wenigstens zwei der in einem Fitting an den Kapazitätsverlust angelegte Geraden Steigungen von betragsmäßig kleiner als 10 % des Mittelwertes der letzten 10 % der gemessenen Kapazitätsverluste aufweisen. Alternativ gelten die Kapazitätsverluste als nahezu konstant, wenn zwei aufeinanderfolgende Kapazitätsverluste und/oder ein gleitender Mittelwert über wenigstens 20 Kapazitätsverluste eine Änderung von weniger als 5% als Kapazitätsverlust aufweisen. Vorteilhaft gewährleistet dieses Vorgehen, dass die Ermittlung der Restkapazität basierend auf dem Kapazitätsverlust schnell und dennoch zuverlässig durchführbar ist.

In einer weiteren vorteilhaften Ausgestaltung und Weiterbildung der Erfindung herrscht in jedem aufeinanderfolgenden Lastzyklus innerhalb einer Bestimmung des Kapazitätsverlusts eine konstante Temperatur. In anderen Worten bedeutet das, dass die Temperatur bei zwei aufeinanderfolgenden Bestimmungen des Kapazitätsverlusts unterschiedlich sein kann. Die Temperatur während eines Lastzyklus ist aber konstant. Vorteilhaft können für das Bestimmen des mittleren Kapazitätsverlusts also Lastzyklen kombiniert werden, die bei unterschiedlichen Temperaturen aufgenommen wurden, solange die Temperatur innerhalb eines Lastzyklus konstant geblieben ist.

Die Batterie oder Batteriezelle kann in einer Temperierkammer betrieben werden. Die Batterie oder Batteriezelle ist in dieser Ausgestaltung in einer Temperierkammer angeordnet. Insbesondere ermöglicht die Temperierkammer, eine ausreichend hohe Temperaturstabilität während eines Lastzyklus der Batterie zu gewährleisten. Alternativ ist es möglich, die Temperatur des Batteriespeichers mittels eines kontaktierenden Temperaturreglers und/oder eines Kühlkreislaufs zu stabilisieren. Vorteilhaft gewährleistet der Einsatz einer Temperierung, dass die Temperatur während einer Bestimmung des Kapazitätsverlusts konstant bleibt. Dies erhöht die Zuverlässigkeit der Bestimmung der Restkapazität des Batteriespeichers vorteilhaft.

In einer weiteren vorteilhaften Ausgestaltung und Weiterbildung der Erfindung wird die untere Spannung aus einem ersten Spannungsbereich und die obere Spannung aus einem zweiten Spannungsbereich ausgewählt. Der zweite Spannungsbereich liegt zweckmäßigerweise bei höheren Spannungen als der erste Spannungsbereich. Besonders vorteilhaft können sowohl der erste Spannungsbereich als auch der zweite Spannungsbereich aus dem gesamten Arbeits-Spannungsbereich des Batteriespeichers gewählt werden. Es müssen in anderen Worten keine Vollzyklen durchgeführt werden. Es ist also möglich, den zugelassen Spannungsbereich des Batteriespeichers gemäß Produktblatt oder darüber hinaus einzusetzen. Vorteilhaft ermöglicht das Messen des Kapazitätsverlusts ohne das Durchführen von Vollzyklen, also einem vollständigen Laden und Entladen, eine kürzere Messdauer. Weiterhin wird der Batteriespeicher weniger stark durch die Messung belastet, was vorteilhaft eine schnelle Alterung verhindert.

Besonders vorteilhaft wird der gleitende Mittelwert für die Bestimmung des mittleren Kapazitätsverlusts aus wenigstens 20 Kapazitätsverlusten ermittelt.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:

Figur 1 eine Vorrichtung Bestimmen des mittleren Kapazitätsverlusts und einer Restkapazität mit einer Hoch-Präzisions-Coulometrie-Vorrichtung,

Figur 2 ein Spannungs-Zeit-Diagramm eines Lastzyklus,

Figur 3 ein Diagramm des zeitlichen Verlaufs der absoluten Ladungsbilanz,

Figur 4 ein Diagramm mit Stromkalibrierungskennlinien vor und nach der Durchführung eines Optimierungsverfahrens,

Figur 5 ein Diagramm der Entladekapazitäten vor der Durchführung des Optimierungsverfahrens,

Figur 6 ein Diagramm der Entladekapazitäten nach der Durchführung des Optimierungsverfahrens,

Figur 7 ein Diagramm mit Werten für die Coulomb-Effizienz vor und nach der Durchführung des Optimierungsverfahrens.

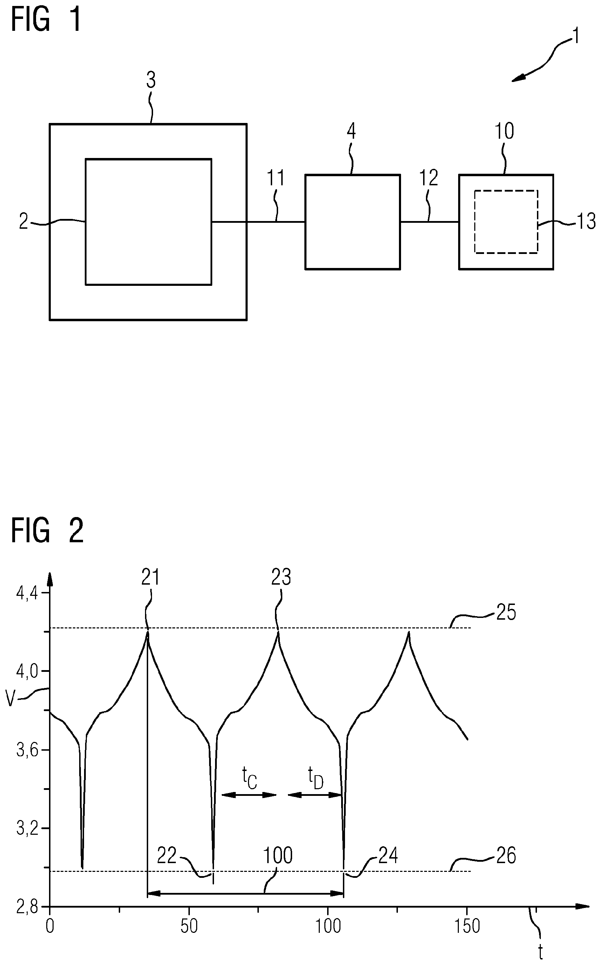

Figur 1 zeigt eine Vorrichtung zum Bestimmen des mittleren Kapazitätsverlusts und der Restkapazität mit einer Hoch-Präzisions-Coulometrie-Vorrichtung 1. Die Vorrichtung 1 umfasst einen Batteriespeicher 2, wobei der Batteriespeicher wenigstens eine Batteriezelle aufweist. Der Batteriespeicher ist in einer Temperierkammer 3 angeordnet ist. Der Batteriespeicher 2 ist über ein Stromkabel 11 mit einer Hoch-Präzisions-Coulometrie-Vorrichtung 4 verbunden. Die Hochpräzisions-Coulometrie-Vorrichtung 4 ist wiederum mit einer Recheneinheit 10 über ein Datenkabel 12 verbunden. Die Hochpräzisions-Coulometrie-Vorrichtung 4 nimmt mit sehr großer Genauigkeit ein Ladungs-Zeit-Diagramm des Batteriespeichers 2 auf. Der Batteriespeicher 2 wird dabei mit einem periodischen Lastzyklus 100 betrieben.

Figur 2 zeigt ein Spannungs-Zeit-Diagramm, das die Hochpräzisions-Coulometrie-Vorrichtung 4 während eines periodischen Lastzyklus 100 des Batteriespeichers 2 aufgezeichnet hat. Ein Lastzyklus 100 umfasst ein Entladen von einem ersten Ladezustand 21 zu einem zweiten Ladezustand 22, wobei der erste Ladezustand 21 bei einer oberen Spannung 25 liegt und der zweite Ladezustand 22 bei einer unteren Spannung 26 liegt. Anschließend wird in dem Lastzyklus 100 der Batteriespeicher 2 von dem zweiten Ladezustand 22 zu einem dritten Ladezustand 23 geladen. Als nächster Schritt wird in dem Lastzyklus 100 der dritte Ladezustand 23 bis zu einem vierten Ladezustand 24 entladen. In jedem einzelnen Lade-/Entladeschritt wird eine obere Spannung 25 und eine untere Spannung 26 als Spannungsgrenzen eingehalten. Das Laden dauert den Ladezeitraum $t_C$. Das Entladen dauert den Entladezeitraum $t_D$.

Basierend auf der in Figur 2 gezeigten Messung kann nun ermittelt werden, welche kumulative Ladungsmenge in den einzelnen Lade- und Entlade-Schritten geflossen ist. Die erste Ladungsmenge Q1 kann über Gleichung 1 berechnet werden, wobei I den Stromfluss und $t_D$ den Entladezeitraum bezeichnet:

$$Q1 = \int I\, dt_D \qquad\qquad \text{Gleichung 1}$$

Innerhalb des Lastzyklus 100 wird der Batteriespeicher 2 anschließend von dem zweiten Ladezustand 22 zu dem dritten Ladezustand 23 mittels eines ersten Ladens 32 geladen. Es wird eine zweite Ladungsmenge Q2 in den Batteriespeicher 2 geladen. Q2 kann mittels der Gleichung 2 berechnet werden:

$$Q2 = \int I\, dt_C \qquad\qquad \text{Gleichung 2}$$

Innerhalb des Lastzyklus 100 wird der Batteriespeicher 2 anschließend von dem dritten Ladezustand 23 zu dem vierten Ladezustand 24 mittels eines zweiten Entladens 33 entladen. Die entnommene Ladungsmenge Q3 kann wiederum analog zu Gleichung 1 aus dem Zeitraum des Entladens dem dazugehörigen Stromfluss berechnet werden.

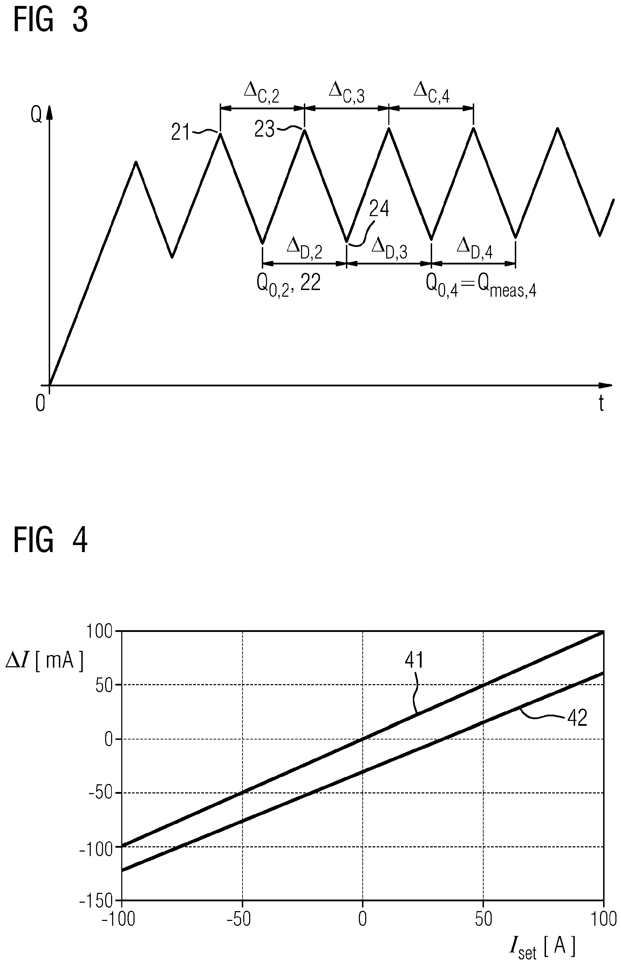

Figur 3 zeigt ein schematisches und stark vereinfachtes Diagramm, in dem der Verlauf der so ermittelten Ladungsmengen Q1...3 über der Zeit aufgetragen ist. Für das weitere Vorgehen wird ein besonderes Augenmerk auf die Entladekapazitäten $Q_{0,i}$ gelegt, beispielsweise die in Figur 3 bezeichneten $Q_{0,2}$ und $Q_{0,4}$. Diese Entladekapazitäten können mit den im Folgenden beschriebenen Gleichungen auf zwei verschiedene Weisen bestimmt werden.

In einer ersten Berechnungsform wird die Entladekapazität $Q_{0,i}$ mittels Gleichung 3 ermittelt. Dabei bezeichnet in allen folgenden Gleichungen der Index i stets einen Zeitpunkt der Aufladung im i-ten Lastzyklus und der Index j stets einen auf diesen Zeitpunkt der Aufladung folgenden Zeitpunkt der Entladung im selben Lastzyklus.

$$Q_{0,i} = \frac{\Delta_{D,j}}{1-CE_i} \qquad\qquad \text{Gleichung 3}$$

Dabei bezeichnet weiterhin $CE_i$ die Coulomb-Effizienz für den entsprechenden Zyklus aus Aufladung und Entladung, also das Verhältnis von entnommener Ladung zur vorher zugeführten Ladung gemäß Gleichung 4

$$CE_i = \frac{Q_i - Q_j}{Q_i - Q_{j-1}} \qquad\qquad \text{Gleichung 4}$$

Unter $\Delta_{D,j}$ wird die Entladedrift verstanden. Diese berechnet sich gemäß Gleichung 5 und gibt die Different von zwei aufeinander folgenden Entladezuständen $Q_j$ und $Q_{j-1}$ an:

$$\Delta_{D,j} = Q_j - Q_{j-1} \qquad\qquad \text{Gleichung 5}$$

Die Entladedrift $\Delta_{D,j}$ ist für mehrere Werte von j in Figur 3 bezeichnet.

In einer zweiten Berechnungsform wird eine - nominell gleiche - Entladekapazität $Q_{meas,i}$ mittels Gleichung 6 ermittelt:

$$Q_{meas,i} = Q_{0,2} + \sum_2^{i-1} \Delta_{Kap,k} \qquad\qquad \text{Gleichung 6}$$

Der hier verwendete Kapazitätsverlust $\Delta_{Kap,k}$ wird berechnet aus der Ladedrift $\Delta_{C,i}$ und der Entladedrift $\Delta_{D,j}$ gemäß Gleichung 7

$$\Delta_{Kap,i} = \Delta_{D,j} - \Delta_{C,i} \qquad\qquad \text{Gleichung 7}$$

Die Entladedrift wurde bereits verwendet und berechnet sich gemäß der oben gegebenen Gleichung 5. Die Ladedrift berechnet sich in einer analogen Weise gemäß Gleichung 8:

$$\Delta_{C,i} = Q_i - Q_{i-1} \qquad\qquad \text{Gleichung 8}$$

Der Wert $Q_{0,i}$ wird also im Wesentlichen aus solchen Größen berechnet, die im i-ten Lastzyklus vorliegen. Der Wert $Q_{meas,i}$ hingegen berechnet sich aus Werten, die sich über den gesamten Messzeitraum zwischen einem initialen Wert, hier beispielhaft $Q_{0,2}$ und dem i-ten Lastzyklus ergeben. Im Falle einer idealen, also fehlerfreien Strommessung sind die beiden Werte gleich, d.h.

$$Q_{0,i} = Q_{meas,i} \hspace{4cm} \texttt{Gleichung 9}$$

Die beiden Werte fallen in der Realität jedoch durch die in der Strommessung vorliegende Stromkalibrierung, die nicht vollkommen exakt ist, auseinander. Je größer die Differenz der Werte, desto fehlerhafter ist die Stromkalibrierung.

Die Gleichung 9 wird in der Form f = $Q_{0,i}$ - $Q_{meas,i}$ als Basis für eine Optimierung verwendet, bei der der Funktionswert f zu minimieren ist. Die für die Optimierung zu variierenden Größen bilden die Stromkalibrierung. Die Stromkalibrierung ist eine Abbildung von einem gemessenen Stromwert auf einen korrigierten Messwert. Wird durch die Optimierung eine weitgehende Übereinstimmung zwischen den Werten $Q_{0,i}$ und $Q_{meas,i}$ erreicht, dann entsprechen die korrigierten Messwerte sehr genau dem realen Stromfluss.

Die Stromkalibrierung kann beispielsweise einen Offsetwert und einen Gain aufweisen. Der Offsetwert bezeichnet einen konstanten Wert, um den der gemessene Strom verschoben wird, während der Gain eine Steigung der Stromkennlinie angibt. Die Optimierung startet mit beliebigen Werten für den Offset und den Gain. Als Startwert für den Offset bietet sich dabei 0 an, also keine Verschiebung.

Die Optimierung wird typischerweise computerbasiert vorgenommen. Dazu können bekannte Programme verwendet werden, denen nur die zu minimierende Funktion und die Randbedingungen und Parameter gegeben werden müssen.

Das Ergebnis einer solchen Optimierung ist in Figur 4 dargestellt. Figur 4 zeigt die Gerade 41, die sich Offset und Gain ergibt, vor der Optimierung, wo es sich um eine Gerade durch den Ursprung und mit Steigung 1/1000 handelt. Weiterhin zeigt Figur 4 die Gerade 42, die sich nach der Optimierung ergibt.

Wie sich zeigt, führt die Optimierung zu einem Offset von etwa -30mA und einer leichten Abweichung des Gain von 1/1000, also einer leichten Drehung der Geraden. Mit diesen Werten für die Stromkalibrierung wird also eine weitgehende Gleichheit von $Q_{0,i}$ und $Q_{meas,i}$ erreicht.

Da die Kalibrierung die Stromwerte verändert, müssen für die Optimierung die Integrale (oder Summen), mit denen die Ladungswerte gebildet werden, also die Gleichungen 1 und 2, neu berechnet werden. Der Stromwert, der in das Integral oder die Summenbildung eingeht, wird verändert zu $I_{korr}(t)$ = Offset + Gain * I(t). Diese Änderung, also die Korrektur der Kalibrierung beeinflusst also die sich ergebenden Ladungswerte, kann aber wegen der Integralbildung nicht einfach direkt an den Ladungswerten Q durchgeführt werden.

Die Optimierung wird dabei im vorliegenden Ausführungsbeispiel anhand einer Messung durchgeführt, die 200 Ladezyklen umfasst. Dabei werden für eine optimale Qualität der Stromkalibrierung eine Mehrzahl von Wertepaaren $Q_{0,i}$ und $Q_{meas,i}$ berücksichtigt, also mehrere Indizes i. Beispielsweise können aus der Messreihe mit 200 Ladezyklen die letzten 50 Wertepaare berücksichtigt werden.

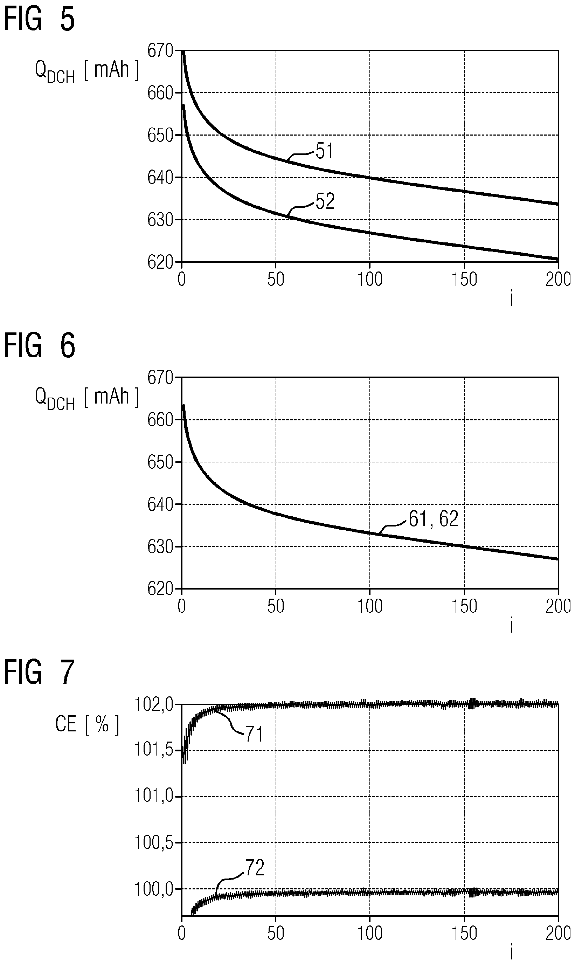

Figur 5 zeigt für das vorliegende Beispiel den Verlauf der Werte $Q_{0,i}$ 51 und $Q_{meas,i}$ 52 vor der Optimierung. Es ist erkennbar, dass die nominell gleichen Werten tatsächlich durch eine leicht fehlerbehaftete Stromkalibrierung um ca. 0,15% auseinander liegen. Eine typischerweise für HPC-Messungen geforderte Genauigkeit von 0,01% für die Strommessung ist daher nicht erreicht. Figur 6 zeigt den Verlauf von $Q_{0,i}$ 61 und $Q_{meas,i}$ 62 nach der Optimierung, d.h. mit einer verbesserten Stromkalibrierung. Es zeigt sich, dass sich beide Verläufe verschieben und die Verläufe 61, 62 nach der Optimierung fast völlig aufeinander liegen, wodurch eine hohe Genauigkeit der Messung erreicht ist. Die so erreichte Genauigkeit erfüllt die Maßgabe einer Genauigkeit von 0,01%.

Figur 7 zeigt, dass die verbesserte Stromkalibrierung auch andere abgeleitete Werte in ihrer Genauigkeit verbessert. Verlauf 71 zeigt das Verhalten der Coulomb-Effizienz nach Gleichung 4 vor der Optimierung. Die Coulomb-Effizienz liegt für weite Bereiche der Messung bei etwa 102%, was nicht möglich ist, da der Batterie nicht mehr Energie entnommen werden kann, als vorher geladen wurde. Es liegt also ein offensichtlicher Messfehler vor. Nach der Optimierung ergibt sich hingegen der Verlauf 72, bei dem die Coulomb-Effizienz von anfänglichen geringeren Werten auf nahezu 100% steigt für den größten Teil der Messung. Zumindest liegt hier also kein offensichtlicher Messfehler mehr vor.

Auch bei einem Ergebnis von unter 100% für die Coulomb-Effizienz ist normalerweise ein Vergleich der absoluten Werte schwierig, da der durch die mangelhafte Stromkalibrierung vorliegende Messfehler größer ist als die Unterschiede zwischen Batteriezellen. Da dieser Fehler durch die Erfindung bei jeder Messung korrigiert und damit fast vollkommen eliminiert wird, wird somit sogar ein Vergleich der absoluten Werte für die Coulomb-Effizienz ermöglicht.

Vorteilhaft enthält die gezeigte Vorgehensweise eine implizite Validierung des Messergebnisses durch Kontrolle des Residuums des Optimierers. Beispielsweise kann als Zielfunktion für das Optimierungsverfahren die auf den Mittelwert der betrachteten Entladekapazität normierte Summe der Differenzen der beiden Gleichungen 3 und 6 für alle Messpunkte implementiert werden. Damit ist sichergestellt, dass für alle Messungen unabhängig von Zellkapazität und Entladetiefe ein einheitliches Maß für die Güte des gefundenen Optimums zur Verfügung steht. Der Optimierer, beispielsweise die MATLAB Funktion "fmincon", kann beispielsweise auf eine Güte von $10^{-6}$ eingestellt werden, bei der der Optimierungs-Vorgang als erfolgreich beendet wird. Wird der Zielwert nicht erreicht, oder bricht der Optimierer aus einem anderen Grund ab, ist die Messung im Detail zu betrachten und gegebenenfalls zu verwerfen. Andernfalls kann die Messung als gültig und ihre Ergebnisse als aussagekräftig eingestuft werden.

Bezugszeichenliste

| | |
|---|---|
| 1 | Vorrichtung zur Vorhersage der Restkapazität |
| 2 | Batteriespeicher |
| 3 | Temperierkammer |
| 4 | Hoch-Präzisions-Coulometrie-Vorrichtung |
| 10 | Recheneinheit |
| 11 | Stromkabel |
| 12 | Datenkabel |
| 13 | Computerprogrammprodukt |
| 21 | erster Ladezustand |
| 22 | zweiter Ladezustand |
| 23 | dritter Ladezustand |
| 24 | vierter Ladezustand |
| 25 | obere Spannung |
| 26 | untere Spannung |
| 100 | Lastzyklus |
| $t_C$ | Ladezeitraum |
| $t_D$ | Entladezeitraum |
| $Q_{0,2}$, $Q_{0,4}$, $Q_{meas,4}$ | Entladekapazitäten |
| $\Delta_{D,j}$ | Entladedrift |
| $\Delta_{C,i}$ | Ladedrift |
| 41 | Stromkalibrierung vor der Optimierung |
| 42 | Stromkalibrierung nach der Optimierung |
| 51, 52 | Entladekapazitäten vor der Optimierung |
| 61, 62 | Entladekapazitäten nach der Optimierung |
| 71, 72 | Coulomb-Effizienz vor und nach der Optimierung |

**Patentansprüche**

1. Verfahren zum Ermitteln wenigstens eines mittleren Kapazitätsverlusts eines Batteriespeichers (2) umfassend die Schritte:

   - Bereitstellen von Ergebnissen einer Messreihe an dem Batteriespeicher (2) mit einer Mehrzahl von Lastzyklen (100), wobei die Lastzyklen (100) eine Ladungsphase und eine Entladungsphase umfassen und wobei die Ergebnisse Werte einer Strommessung umfassen,
   - Ermitteln einer ersten und einer zweiten Entlade-Kapazität ($Q_{0,i}$, $Q_{meas,i}$) des Batteriespeichers (2) aus den Ergebnissen der Messreihe durch eine erste und eine zweite Rechenvorschrift, wobei eine Kalibrierung der Strommessung unterschiedlich in die erste und zweite Rechenvorschrift eingeht, wobei die Kalibrierung eine Rechenvorschrift zur Korrektur von Werten der Strommessung ist,
   - Durchführen eines Optimierungsverfahrens derart, dass eine Kalibrierung der Strommessung ermittelt wird, mit der die größte Übereinstimmung der ermittelten ersten und zweiten Entlade-Kapazität ($Q_{0,i}$, $Q_{meas,i}$) erreicht ist.

2. Verfahren nach Anspruch 1, bei dem die erste Entlade-Kapazität ($Q_{0,i}$) für einen Lastzyklus (100) aus einer Entladedrift für den Lastzyklus (100) und einer Coulomb-Effizienz für den Lastzyklus (100) berechnet wird.

3. Verfahren nach Anspruch 1, bei dem die erste Entlade-Kapazität ($Q_{0,i}$) für einen Lastzyklus (100) aus einem Kapazitätswert nach der Ladephase des Lastzyklus (100) und einem Kapazitätswert vor dieser Ladephase berechnet wird.

4. Verfahren nach einem der vorangehenden Ansprüche, bei dem die zweite Entlade-Kapazität ($Q_{meas,i}$) für einen Lastzyklus aus einer ersten Entlade-Kapazität für einen weiteren, vorangehenden Lastzyklus und einer Summe aus Kapazitätsverlusten von zwischen dem Lastzyklus und dem weiteren Lastzyklus liegenden Lastzyklen ermittelt wird.

5. Verfahren nach einem der vorangehenden Ansprüche, bei dem für die Berechnung und Optimierung der Kalibrierung ein Offset-Wert verwendet wird, der eine Differenz zwischen realem und gemessenem Stromwert bei einem Strom von 0 A angibt und ein Steigungswert verwendet wird, der einen Proportionalitätsfaktor zwischen realem und gemessenem Strom angibt.

6. Verfahren nach einem der Ansprüche 1 bis 4, bei dem für die Berechnung und Optimierung der Kalibrierung ein Krümmungsfaktor verwendet wird, der einen nichtlinearen, insbesondere quadratischen Zusammenhang zwischen realem und gemessenem Strom angibt.

7. Verfahren nach einem der Ansprüche 1 bis 4, bei dem für die Berechnung und Optimierung der Kalibrierung der Zusammenhang zwischen realem und gemessenem Strom als ein abschnittsweise linearer Zusammenhang mit wenigstens drei Stützpunkten modelliert wird.

8. Verfahren nach einem der vorangehenden Ansprüche, bei dem die Ergebnisse der Messreihe mittels einer Hoch-Präzisions-Coulometrie-Vorrichtung (4) erzeugt werden.

9. Verfahren nach einem der vorangehenden Ansprüche, bei dem das Laden und Entladen des Lastzyklus (100) zwischen einer unteren Spannung (26) und einer oberen Spannung (25) des Batteriespeichers (2) erfolgt.

10. Verfahren nach einem der vorangehenden Ansprüche, bei dem in jedem aufeinanderfolgenden Lastzyklus (100) innerhalb des Lastzyklus eine konstante Temperatur herrscht.

11. Verfahren nach einem der vorangehenden Ansprüche, bei dem eine erste Ladungsverschiebung als Differenz eines ersten oberen Ladungszustands (24) und eines zweiten oberen Ladungszustands (22) ermittelt wird und bei dem eine zweiten Ladungsverschiebung als Differenz eines ersten unteren Ladungszustands (23) und eines zweiten unteren Ladungszustands (21) ermittelt wird und bei dem ein Kapazitätsverlust aus der Differenz der ersten Ladungsverschiebung und der zweiten Ladungsverschiebung bestimmt wird.

12. Verfahren nach einem der vorangehenden Ansprüche, bei dem Lastzyklen (100) durchgeführt werden, bis der Kapazitätsverlust in zwei oder mehr aufeinanderfolgenden Lastzyklen (100) nahezu konstant ist.

13. Verfahren nach einem der vorhergehenden Ansprüche, wobei das Verfahren computergestützt in einer Recheneinheit (10) erfolgt.

14. Vorrichtung (1) zum Durchführen des Verfahrens nach einem der vorangehenden Ansprüche umfassend einen Speicher zur Aufnahme von Ergebnissen einer Messreihe an dem Batteriespeicher (2) mit einer Mehrzahl von Lastzyklen (100), wobei die Lastzyklen (100) eine Ladungsphase und eine Entladungsphase umfassen und wobei die Ergebnisse Werte einer Strommessung umfassen, und eine Recheneinheit (10), wobei die Recheneinheit (10) ausgestaltet ist,

- zur Berechnung einer ersten und einer zweiten Entlade-Kapazität ($Q_{0,i}$, $Q_{meas,i}$) des Batteriespeichers (2) aus den Ergebnissen der Messreihe durch eine erste und eine zweite Rechenvorschrift, wobei eine Kalibrierung der Strommessung unterschiedlich in die erste und zweite Rechenvorschrift eingeht, wobei die Kalibrierung eine Rechenvorschrift zur Korrektur von Werten der Strommessung ist,
- ein Optimierungsverfahrens derart durchzuführen, dass eine Kalibrierung der Strommessung ermittelt wird, mit der die größte Übereinstimmung der ermittelten ersten und zweiten Entlade-Kapazität ($Q_{0,i}$, $Q_{meas,i}$) erreicht ist.

15. Computerprogrammprodukt (13), welches direkt in einen Speicher der Vorrichtung aus dem Anspruch 14 ladbar ist, mit Programmcode-Mitteln, um ein Verfahren nach einem der Ansprüche 1 bis 13 auszuführen, wenn das Computerprogrammprodukt (13) in der Recheneinheit (10) der Vorrichtung aus dem Anspruch 14 ausgeführt wird.

**Claims**

1. Method for ascertaining at least one mean capacity loss of a battery storage device (2) comprising the steps:

   - providing results of a measurement series on the battery storage device (2) with a plurality of load cycles (100), wherein the load cycles (100) comprise a charging phase and a discharging phase and wherein the results comprise values of a current measurement,
   - ascertaining a first and a second discharge capacity ($Q_{0,i}$, $Q_{meas,i}$) of the battery storage device (2) from the results of the measurement series by way of a first and a second calculation rule, wherein a calibration of the current measurement is included differently in the first and the second calculation rule, wherein the calibration is a calculation rule for correcting values of the current measurement,
   - carrying out an optimisation process such that a calibration of the current measurement is ascertained with which the greatest match of the ascertained first and second discharge capacity ($Q_{0,i}$, $Q_{meas,i}$) is achieved.

2. Method according to claim 1, in which the first discharge capacity ($Q_{0,i}$) for a load cycle (100) is calculated from a discharge drift for the load cycle (100) and a coulomb efficiency for the load cycle (100).

3. Method according to claim 1, in which the first discharge capacity ($Q_{0,i}$) for a load cycle (100) is calculated from a capacity value after the charging phase of the load cycle (100) and a capacity value before said charging phase.

4. Method according to one of the preceding claims, in which the second discharge capacity ($Q_{meas,i}$) for a load cycle is ascertained from a first discharge capacity for a further preceding load cycle and a sum of capacity losses of load cycles arranged between the load cycle and the further load cycle.

5. Method according to one of the preceding claims, in which, for the calculation and optimisation of the calibration, an offset value is used which defines a difference between the real and the measured current value at a current of 0A and a gradient value is used which defines a proportionality factor between the real and the measured current.

6. Method according to one of claims 1 to 4, in which, for the calculation and optimisation of the calibration, a curvature factor is used which defines a non-linear, in particular quadratic, relationship between the real and the measured current.

7. Method according to one of claims 1 to 4, in which, for the calculation and optimisation of the calibration, the relation between the real and the measured current is modelled as a partially linear relation with at least three interpolation points.

8. Method according to one of the preceding claims, in which the results of the measurement series are generated by means of a high precision coulometry apparatus (4).

9. Method according to one of the preceding claims, in which the charging and discharging of the load cycle (100) takes place between a lower voltage (26) and an upper voltage (25) of the battery storage device (2).

10. Method according to one of the preceding claims, in which in each successive load cycle (100), a constant temperature prevails within the load cycle.

11. Method according to one of the preceding claims, in which a first charge displacement is ascertained as the difference between a first upper state of charge (24) and a second upper state of charge (22) and in which a second charge displacement is determined as the difference between a first lower state of charge (23) and a second lower state of charge (21) and in which a capacity loss is determined from the difference between the first charge displacement and the second charge displacement.

12. Method according to one of the preceding claims, in which load cycles (100) are carried out until the capacity loss in two or more successive load cycles (100) is almost constant.

13. Method according to one of the preceding claims, wherein the method takes place in a computer-assisted manner in a computing unit (10).

14. Apparatus (1) for carrying out the method according to one of the preceding claims comprising a memory store for receiving results of a measurement series on the battery storage device (2) with a plurality of load cycles (100), wherein the load cycles (100) comprise a charging phase and a discharging phase and wherein the results comprise values of a current measurement, and a computing unit (10), wherein the computing unit (10) is configured

- for calculating a first and a second discharge capacity ($Q_{0,i}$, $Q_{meas,i}$) of the battery storage device (2) from the results of the measurement series by way of a first and a second calculation rule, wherein a calibration of the current measurement is included differently in the first and the second calculation rule, wherein the calibration is a calculation rule for correcting values of the current measurement,
- carrying out an optimisation process such that a calibration of the current measurement is ascertained with which the greatest match of the ascertained first and second discharge capacity ($Q_{0,i}$, $Q_{meas,i}$) is achieved.

15. Computer program product (13) which can be directly loaded into a memory store of the apparatus from claim 14, having program code means in order to carry out a method according to one of claims 1 to 13 when the computer program product (13) is executed in the computing unit (10) of the apparatus from claim 14.

**Revendications**

1. Procédé de détermination d'au moins une perte moyenne de capacité d'un accumulateur (2) à batterie comprenant les stades :

   - on se procure des résultats d'une série de mesures sur l'accumulateur (2) à batterie par une pluralité de cycles (100) de charge, dans lequel les cycles (100) de charge comprennent une phase de charge et une phase de décharge et dans lequel les résultats comprennent des valeurs d'une mesure de courant,
   - on détermine une première et une deuxième capacités ($Q_{0,i}$, $Q_{meas,i}$) de décharge de l'accumulateur (2) à batterie, à partir des résultats de la série de mesures par une première et une deuxième prescriptions de calcul, dans lequel un étalonnage de la mesure du courant entre d'une manière différente dans la première et la deuxième prescriptions de calcul, dans lequel l'étalonnage est une prescription de calcul pour la correction de valeurs de la mesure du courant,
   - on effectue un procédé d'optimisation de manière à déterminer un étalonnage de la mesure du courant, par lequel la coïncidence la plus grande, entre les première et deuxième capacités ($Q_{0,i}$, $Q_{meas,i}$) de décharge déterminées, est atteinte.

2. Procédé suivant la revendication 1, dans lequel on calcule la première capacité ($Q_{0,i}$) de décharge pour un cycle (100) de charge, à partir d'une dérive de décharge pour le cycle (100) de charge et d'une efficacité de Coulomb pour le cycle (100) de charge.

3. Procédé suivant la revendication 1, dans lequel on calcule la première capacité ($Q_{0,i}$) de décharge pour un cycle (100) de charge, à partir d'une valeur de capacité, après la phase de charge du cycle (100) de charge et d'une valeur de capacité avant cette phase de charge.

4. Procédé suivant l'une des revendications précédentes, dans lequel on détermine la deuxième capacité ($Q_{meas,i}$) de décharge pour un cycle de charge, à partir d'une première capacité de décharge pour un autre cycle de charge précédent et d'une somme des pertes de capacités= de cycles de charge entre le cycle de charge et l'autre cycle de charge.

5. Procédé suivant l'une des revendications précédentes, dans lequel, pour le calcul et l'optimisation de l'étalonnage, on utilise une valeur de décalage, qui indique une différence entre valeur de courant réelle et mesurée à un courant de 0 A et qui utilise une valeur de croissance, qui indique un facteur de proportionnalité entre courant réel et mesuré.

6. Procédé suivant l'une des revendications 1 à 4, dans lequel on utilise, pour le calcul et l'optimisation de l'étalonnage, un facteur de courbure, qui indique une relation non linéaire, en particulier quadratique, entre courant réel et mesuré.

7. Procédé suivant l'une des revendications 1 à 4, dans lequel, pour le calcul et l'optimisation, on modélise l'étalonnage de la relation entre courant réel et mesuré, sous la forme d'une relation linéaire par tronçons ayant au moins trois points d'appui.

8. Procédé suivant l'une des revendications précédentes, dans lequel on produit les résultats de la série de mesures au moyen d'un dispositif (4) de coulométrie de grande précision.

9. Procédé suivant l'une des revendications précédentes, dans lequel la charge et la décharge du cycle (100) de charge s'effectue entre une tension (26) inférieure et une tension (25) supérieure de l'accumulateur (2) à batterie.

10. Procédé suivant l'une des revendications précédentes, dans lequel il règne, dans chaque cycle (100) de charge successif, à l'intérieur du cycle de charge, une température constante.

11. Procédé suivant l'une des revendications précédentes, dans lequel on détermine un premier décalage de charge, sous la forme d'une différence entre un premier état (24) de charge supérieur et un deuxième état (22) de charge supérieur, et dans lequel on détermine un deuxième décalage de charge, sous la forme d'une différence d'un premier état (23) de charge inférieur et d'un deuxième état (21) de charge inférieur, et dans lequel on détermine une perte de capacité, à partir de la différence entre le premier décalage de charge et le deuxième décalage de charge.

12. Procédé suivant l'une des revendications précédentes, dans lequel on effectue des cycles (100) de charge, jusqu'à ce que la perte de capacité, dans deux ou plusieurs cycles (100) de charge successifs, soit à peu près constante.

13. Procédé suivant l'une des revendications précédentes, dans lequel on effectue le procédé de manière assistée par ordinateur dans une unité (10) informatique.

14. Dispositif (1) pour effectuer le procédé suivant l'une des revendications précédentes comprenant une mémoire d'enregistrement de résultats d'une série de mesures sur l'accumulateur (2) à batterie par une pluralité de cycles (100) de charge, dans lequel les cycles (100) de charge comprennent une phase de charge et une phase de décharge et dans lequel les résultats comprennent des valeurs d'une mesure de courant, et une unité (10) informatique, dans lequel l'unité (10) informatique est conformée,

   - pour le calcul d'une première et une deuxième capacités ($Q_{0,i}$, $Q_{meas,i}$) de décharge de l'accumulateur (2) à batterie, à partir des résultats de la série de mesures par une première et une deuxième prescriptions de calcul, dans lequel un étalonnage de la mesure du courant entre d'une manière différente dans la première et la deuxième prescriptions de calcul, dans lequel l'étalonnage est une prescription de calcul pour la correction de valeurs de la mesure du courant,
   - pour effectuer un procédé d'optimisation de manière à déterminer un étalonnage de la mesure du courant, par lequel la coïncidence la plus grande, entre les première et deuxième capacités ($Q_{0,i}$, $Q_{meas,i}$) de décharge déterminées, est atteinte.

15. Produit (13) de programme d'ordinateur, qui peut être chargé directement dans une mémoire du dispositif de la revendication 14, comprenant des moyens de code de programme, pour effectuer un procédé suivant l'une des revendications 1 à 13, lorsque le produit (13) de programme d'ordinateur est réalisé dans l'unité (10) informatique du dispositif de la revendication 14.

FIG 1

FIG 2

## FIG 3

## FIG 4

FIG 5

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ZHANG SHUZHUI.** A rapid online calculation method for state of health of lithium-ion battery based on Coulomb counting method and differential voltage analysis. *J. of Power Source,* 2020, vol. 479